Europäisches Patentamt

European Patent Office

Office européen des brevets

(19)

(11) Numéro de publication: **0 305 269**
**A1**

(12) **DEMANDE DE BREVET EUROPEEN**

(21) Numéro de dépôt: **88402101.5**

(22) Date de dépôt: **12.08.88**

(51) Int. Cl.⁴: **H 01 J 37/32**
**C 23 F 4/00**

(30) Priorité: **20.08.87 FR 8711754**

(43) Date de publication de la demande:
**01.03.89 Bulletin 89/09**

(84) Etats contractants désignés:
**BE CH DE ES FR GB IT LI NL SE**

(71) Demandeur: **L'AIR LIQUIDE, SOCIETE ANONYME POUR L'ETUDE ET L'EXPLOITATION DES PROCEDES GEORGES CLAUDE**
**75, Quai d'Orsay**
**F-75321 Paris Cédex 07 (FR)**

(72) Inventeur: **Rufin, Denis**
**Chicago Research Center 5230 S. East Ave.**
**Countryside IL 60525 (US)**

**Hirase, Ikuo**
**L'Air Liquide Lab. 5-9-9, Tokodai, Toyosato-machi**
**Tsucuba-Gun Ibaraki-Pref.-300-26 (JP)**

(74) Mandataire: **Bouton Neuvy, Liliane et al**
**L'Air liquide, Société Anonyme pour L'Etude et L'Exploitation des Procédés Georges Claude 75, Quai d'Orsay**
**F-75321 Paris Cédex 07 (FR)**

(54) Procédé de contrôle en temps réel de la sélectivité de la gravure par analyse des gaz du plasma dans un procédé de gravure ionique réactive et réacteur pour sa mise en oeuvre.

(57) La présente invention concerne un procédé de contrôle en temps réel de la gravure dans un procédé de fabrication de composants électroniques du type par gravure ionique réactive de tranches de silicium mettant en oeuvre un plasma crée entre deux électrodes, caractérisé en ce que l'on analyse les espèces gazeuses du plasma au cours de la gravure, l'une au moins des tranches de silicium pouvant être in situ soustraite à l'influence du plasma.

Elle concerne également un réacteur pour sa mise en oeuvre comportant une enceinte sous vide 31 comportant au moins une électrode-support 34 et une électrode 35 réliée à la masse entre lesquelles est créé un plasma, des moyens de mise sous vide, des moyens de chargement et déchargement des tranches, des moyens d'introduction de gaz de gravure, caractérisé en ce qu'il comporte au moins deux emplacements 40 de tranche 33, des moyens pour soustraire au moins un emplacement à l'influence du plasma 37, lesdits moyens et les emplacements étant mobiles les uns par rapport aux autres, et des moyens d'analyse des espèces gazeuses du plasma.

FIG.3

## Description

"PROCEDE DE CONTROLE EN TEMPS REEL DE LA SELECTIVITE DE LA GRAVURE PAR ANALYSE DES GAZ DU PLASMA DANS UN PROCEDE DE GRAVURE IONIQUE REACTIVE ET REACTEUR POUR SA MISE EN OEUVRE"

La présente invention concerne un procédé de contrôle en temps réel de la sélectivité de la gravure dans un procédé de gravure ionique réactive par analyse des espèces gazeuses du plasma, ainsi qu'un réacteur pour sa mise en oeuvre.

Dans le domaine de la fabrication de composants électroniques, et plus particulièrement dans le domaine du traitement par gravure de tranches de silicium, il est important de contrôler l'uniformité de la gravure.

La gravure consiste à éliminer, en certains emplacements seulement, la couche de silice préalablement déposée sur le substrat en silicium (sous-couche), les emplacements étant définis par un masque en résine déposé sur la couche.

Un premier problème de l'anisotropie de la gravure est résolu par le choix de la technique par gravure sèche qui assure la perpendicularité des bords des trous gravés par rapport à la surface des couches, alors qu'au contraire, la gravure dite humide est isotrope et induit une attaque latérale des bords des trous. C'est pourquoi la présente invention s'applique dans le domaine de la gravure sèche, notamment la gravure ionique réactive.

Un second problème réside dans le fait qu'il est difficile de contrôler la sélectivité de la gravure, c'est-à-dire le fait que seule la couche doit être éliminée, sans que la sous-couche soit atteinte.

La sélectivité, et donc finalement l'uniformité de la gravure doivent donc pouvoir être contrôlées pour la mise au point du procédé de gravure ionique réactive.

La gravure consiste à soumettre la tranche de silicium à un plasma créé entre deux électrodes en vis à vis dont l'une est une électrode-support (cathode) où sont disposées les tranches à graver. Un plasma est produit et entretenu entre les électrodes dont l'une est couplée à un générateur de puissance HF et l'autre est à la masse comme cela apparaît sur les figures.

Les radicaux et espèces neutres participent à des réactions chimiques à la surface exposée au plasma pour produire des espèces volatiles ou des précurseurs. Les ions positifs sont accélérés dans le champ interélectrode, bombardent la surface des tranches et initialisent ou complètent la volatilisation et accélèrent l'attaque du matériau à éliminer aux emplacements laissés libres par le masque.

On peut augmenter l'énergie des ions et des espèces réactives en augmentant la puissance (le voltage) ou en diminuant la pression. Ces paramètres influent directement sur la vitesse de la gravure.

Pour contrôler la sélectivité dans diverses conditions de gravure ionique réactive, et trouver les conditions optimales compte tenu du choix des gaz et des paramètres définis par les dispositifs de gravure (qualité du vide, pression, puissance de radiofréquence, distance des electrodes, composition des electrodes,...) un procédé classique consiste à faire varier un à un chacun de ces paramètres et à mesurer la différence d'épaisseur entre les couches à l'aide d'un profilomètre avant et après la gravure. Cette méthode est précise et permet de connaitre exactement le degré de gravure de chaque matériau en tout point d'un échantillon.

Cependant, cette méthode au profilomètre est très lourde compte tenu du grand nombre de paramètres à faire varier et des opérations qu'il est nécessaire d'effectuer pour chaque mesure (introduction de l'échantillon dans le réacteur, mise sous vide, création du plasma, gravure, interruption du plasma et sortie de l'échantillon).

De plus, le manque de reproductibilité des atmosphères plasma rend difficile la comparaison entre différents essais qui sont inévitablement séparés par des interruptions du plasma.

Ce problème est résolu selon l'invention qui propose un procédé de contrôle en temps réel de la gravure et qui permet sa mise au point sans interruption temporelle du plasma.

Ainsi la présente invention concerne un procédé de contrôle en temps réel de la gravure dans un procédé de fabrication de composants électroniques du type par gravure ionique réactive de tranches de silicium mettant en oeuvre un plasma crée entre deux électrodes, caractérisé en ce que l'on analyse les espèces gazeuses de plasma au cours de la gravure, l'une au moins des tranches de silicium pouvant être in situ soustraite à l'influence de plasma.

L'atmosphère gazeuse contient les produits volatiles des matériaux exposés au plasma. Ces produits sont formés par les réactions chimiques entre la surface des matériaux à graver et certaines espèces gazeuses réactives présentes dans la plasma sous l'action essentielle du bombardement ionique qui active ces réactions.

L'analyse des gaz issus reflète directement l'avancement de la gravure et permet, par exemple, la détection de fin d'attaque.

En effet, la quantité de produits volatiles émise est directement proportionnelle à la vitesse de gravure du matériau à graver et à la surface de la tranche.

Par exemple, pour un tranche de 100 mm de diamètre et une vitesse de gravure de 100 nm/mm, les proportions de $SiF_4$ dans l'atmosphère gazeuse sont de :
- 3,63 % dans le cas d'une tranche de Si
- 1,95 % dans le cas d'une tranche de $SiO_2$.

La présente invention concerne en outre un réacteur pour la gravure ionique réactive de tranches de silicium du type à enceinte sous vide comportant au moins une électrode-support reliée à un générateur et une électrode réliée à la masse entre lesquelles est créé un plasma, des moyens de mise sous vide, des moyens de chargement et déchargement des tranches, des moyens d'introduction de gaz de gravure, caractérisé en ce qu'il comporte au moins deux emplacements de tranche, des moyens pour soustraire au moins un emplacement à l'influence du plasma, lesdits moyens et les emplacements étant mobiles les uns par rapport aux autres, et des moyens d'analyse des gaz plasmatiques.

D'autres caractéristiques et avantages de l'invention apparaîtront à la lecture des exemples ci-après et au vu des dessins annexés où :

- les figures 1, 2a et 2b représentent schématiquement en coupe des dispositifs classiques de mise en oeuvre de gravure ionique réactive,

- la figure 3 représente schématiquement un réacteur selon l'invention.

- les figures 4,5,6 et 7 représentent des résultats d'analyses décrits dans les exemples.

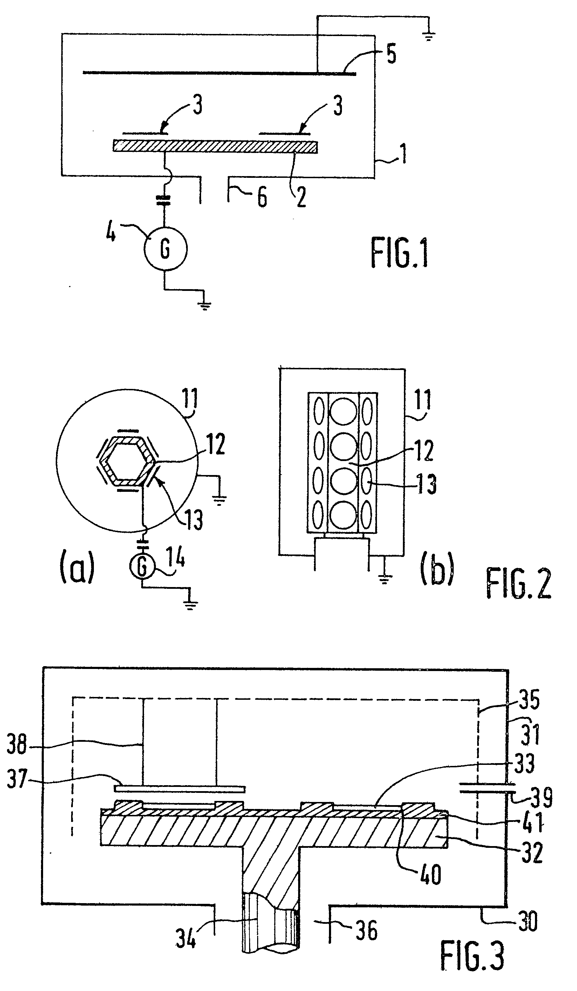

Sur la figure 1 apparait un réacteur classique pour la gravure ionique réactive. L'enceinte 1 comporte une électrode-support 2 reliée à un générateur G 4. Les tranches de silicium 3 sont disposées sur l'électrode-support 2, en regard de l'électrode 5 reliée à la masse. L'orifice 6 permet l'évacuation par pompage des effluents plasmatiques et la mise sous vide.

Sur les figures 2 a et b est représentée une variante dite "hexode" du réacteur, qui permet de traiter un nombre plus important de tranches 13 disposées sur une électrode-support 12 à section hexagonale et reliée de la même façon à un générateur G 14. Sur ces figures, l'enceinte 11 est représentée elle-même reliée à la masse.

La figure 3 représente en coupe un mode de réalisation d'un réacteur selon l'ivention.

Les moyens usuels de chargement et déchargement et d'introduction des gaz de gravure ne sont pas représentés.

Dans l'enceinte cylindrique 31 est disposée une électrode-support ronde 32. Le fond 30 de l'enceinte 31 est munie d'un manchon 36 par lequel passe une tige 34 supportant l'électrode-support 32 et reliée à des moyens de mise sur rotation de l'électrode-support 32 et à un générateur de fréquence non représentés. Une autre électrode 35 formant cage est maintenue par des moyens classiques en regard de l'électrode-support 32. Les moyens de mise à la masse de l'électrode 35 et de l'enceinte ne sont pas représentés. Le manchon 36 est de plus relié à des moyens de mise sous vide de l'enceinte 31, comme une pompe (non représentée). Sur l'électrode-support 32 est disposé un plateau 41 pourvu d'alvéoles circulaires 40 où sont disposées les tranches de silicium 33.

Un tube de prélèvement 39 traverse à joint étanche la paroi de l'enceinte 31. L'extrémité du tube 39 débouche à l'intérieur de l'enceinte et de l'électrode formant cage 35. L'extrémité du tube 39 extérieure à l'enceinte 31 est reliée à des moyens d'analyse des espèces gazeuses du plasma prélevées (non représentés).

Comme moyens d'analyse des gaz, on peut utiliser tout moyen usuel capable de détecter ces espèces gazeuses, comme un spectromètre pour l'analyse par spectroscopie de masse quadripolaire (QMS) ou par spectroscopie d'émission optique (SEO).

Un écran 37 en alliage d'aluminium (AG 3-5) est suspendu à 1mm au-dessus du niveau des tranches de silicium 33, au moyen de vis en acier inoxydable 38.

Tout autre matériau conducteur et en particulier métallique neutre au plasma est susceptible de convenir. Ainsi, Al convient dans les plasmas fluorocarbonés car le composé $AlF_3$ n'est pas volatile. Tout matériau conducteur tefloné est également susceptible de convenir.

D'autres modes de réalisation non représentés consistent à pourvoir par exemple un réacteur tel que représenté aux figures 2a et b d'un écran soustrayant une tranche ou une rangée de tranches au plasma par un écran fixé dans l'enceinte. On peut également envisager en variante un écran susceptible de se déplacer dans l'enceinte en face de tranches successives, ou un écran masquant plusieurs tranches, ou encore plusieurs écrans.

Les moyens d'introduction de gaz de gravure, ne sont pas représentés. Ils sont usuellement constitués, par un orifice d'introduction contrôlée de gaz dans l'enceinte relié à une des sources de gaz. Mais le matériau de l'électrode-support et/ou du plateau portant les électrodes peut également dégager sous l'action du plasma des molécules susceptibles de participer au réaction d'attaque, comme c'est le cas avec le téflon (polytétrafluoréthylène).

Le réacteur selon l'invention est mis en oeuvre comme tout réacteur pour la gravure ionique réactive, quels que soient les matériaux gravés ou les gaz de gravure.

Il est connu que le plasma formé comporte à son pourtour une gaine d'une épaisseur de l'ordre du millimètre. L'écran pour être efficace est placé au-dessus de la tranche et en-dessous de la surface externe du dessous de la gaine.

D'autres caractéristiques et avantages de l'invention apparaîtront à la lecture des exemples ci-après qui montrent dans le cas particulier de Si et $SiO_2$ gravés à l'aide de plasmas fluorocarbonés, comment il est possible de trouver les conditions optimales de gravure.

Exemple 1.

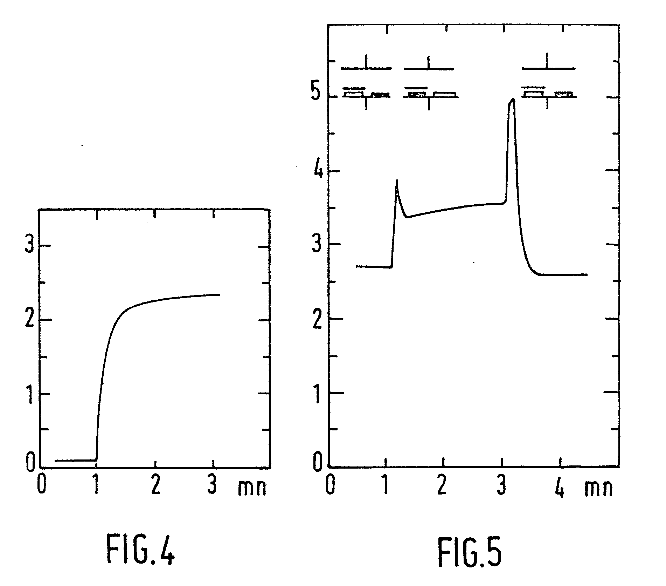

Dans un réacteur selon l'invention, un seul emplacement de tranche est occupé sur la cathode par une tranche dont la surface exposée est constituée de $SiO_2$ et la gravure a été effectuée avec un plasma $CF_4$. La tranche est restée sous l'écran un minute, puis on a effectué la rotation de 180°. L'analyse des quantités de $SiF_4$ au cours de la gravure (représenté à la figure 4, temps en mn), révèle qu'un signal 22,5 fois plus fort (2,25/0,1) apparait quand la surface est exposée au plasma. Ceci permet de conclure que $SiF_4$ provient de la tranche quand elle est exposée.

Exemple 2

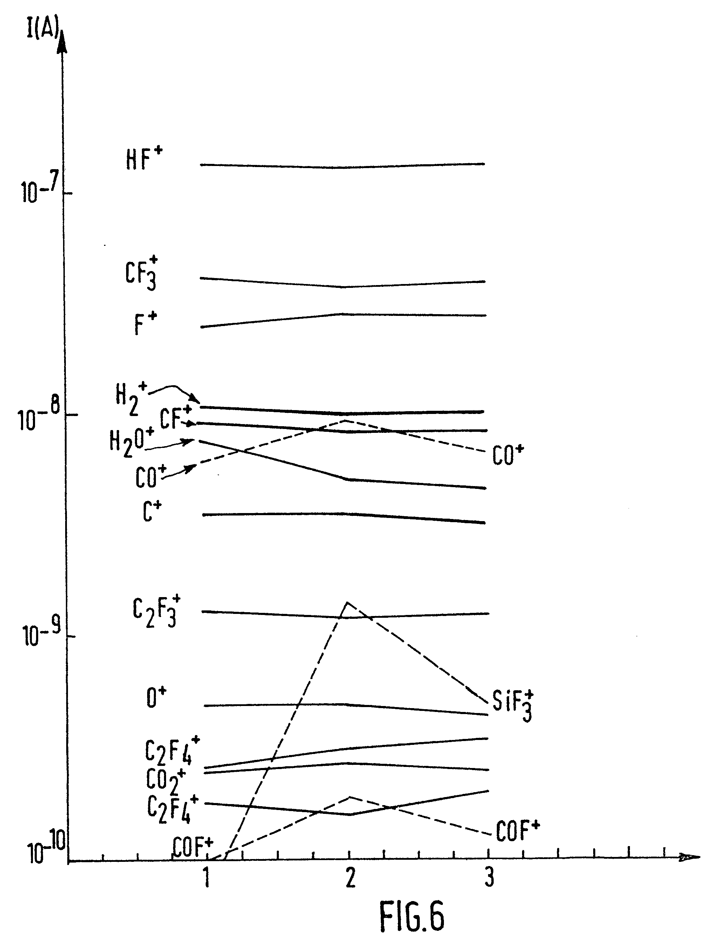

Dans un réacteur analogue, un emplacement étant occupé par une tranche de silicium (noir) et un autre par une tranche dont la surface exposée est constituée de $SiO_2$ (blanc), avec un plasma $C_3F_8$, l'analyse de $SiF_4$ a été effectuée pour différentes positions des tranches par rapport à l'écran. Les résultats sont représentés à la figure 5. Cette analyse permet d'attribuer à chaque matériau exposé la quantité de $SiF_4$ émise : dans une première phase (1ère minute), seule la tranche de silicium est exposée, la tranche de $SiO_2$ étant masquée par l'écran représenté par une barre sur le schéma ; $SiO_2$ est ensuite seule exposée durant la 2ème et la 3ème minute, puis de nouveau Si seul durant la 4ème minute. On attribue le premier et le troisième plateau à Si, et le second plateau à $SiO_2$.

Durant la rotation, lorsqu'aucune des tranches n'est préservée du plasma, on observe des pics dans les quantités de $SiF_4$ dégagées.

Exemple 3

L'analyse QMS des différentes espèces gazeuses présentes dans un plasma $CF_4$ a été réalisée sans interruption du plasma et présentée à la figure 6 pour différents matériaux à graver.

1 - pas de tranche (mesure de référence)

2 - tranche Si sous l'écran, tranche $SiO_2$ exposée au plasma

3 - tranche $SiO_2$ sous l'écran, tranche Si exposée au plasma.

Les ions $SiF_3^+$, $CO^+$ et $COF^+$ sont représentatifs des espèces $SiF_4$, (provenant de Si et/ou $SiO_2$) et CO, $COF_2$ et COF (provenant de $SiO_2$). En ordonnée, est mesuré le courant ionique (en A). D'autres ions, moins significatifs ont également été détectés à l'analyse QMS.

Exemple 4

Ces analyses permettent de déterminer les conditions optimales pour la sélectivité, par l'étude de l'évolution des émissions de $SiF_4$ en fonction de la composition gazeuse par la méthode de l'écran selon l'invention.

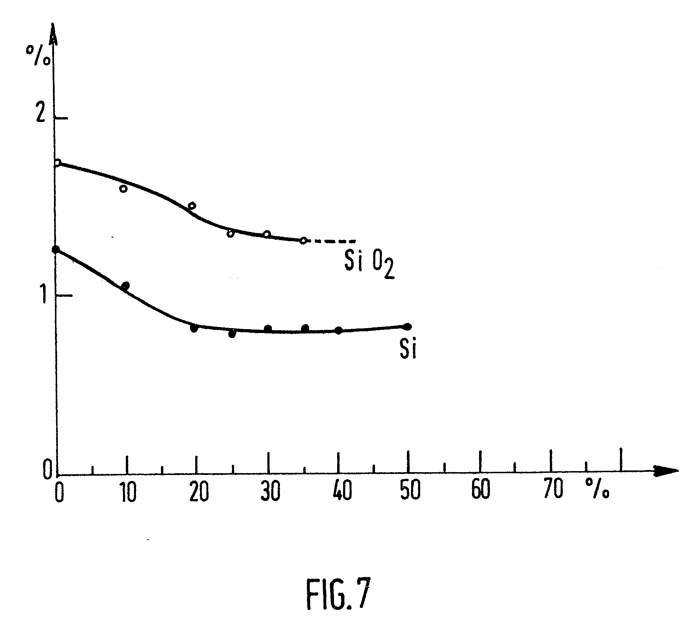

La figure 7 représente le pourcentage de $SiF_4$ provenant de $SiO_2$ (ronds) et de Si (points) présent dans le plasma $CH_4/C_2F_6$, en fonction du pourcentage de $CH_4$ dans le $C_2F_6$.

Il apparaît que la différence entre les courbes est plus grande autour de 20 % de $CH_4$ dans $C_2F_6$ ; le mélange optimal est celui pour lequel le ratio des émissions relatives de $SiF_4$ est plus grand.

De manière analogue, on a pu déterminer que 70 % de $H_2$ dans $C_3F_8$, 40 % de $H_2$ dans $CF_4$ et 20 % de $CH_4$ dans $CF_4$ sont favorables à une bonne sélectivité.

Exemple 5

Ce procédé permet également de déterminer que l'attaque d'une couche de $SiO_2$ sur Si est terminée quand l'analyse spectroscopique (SEO pour CO, ou QMS pour CO ou $SiF_4$) révèle une diminution des taux de produits provenant de la décomposition de $SiO_2$. On peut ainsi par le procédé selon l'invention, réaliser la détection de fin d'attaque.

**Revendications**

1. Procédé de contrôle en temps réel de la gravure dans un procédé de fabrication de composants électroniques du type par gravure ionique réactive de tranches de silicium mettant en oeuvre un plasma créé entre deux électrodes, caractérisé en ce que l'on analyse les espèces gazeuses du plasma au cours de la gravure, l'une au moins des tranches de silicium pouvant être in situ soustraite à l'influence du plasma.

2. Procédé selon la revendication 1, caractérisé en ce que l'on soustrait ladite tranche à l'influence du plasma par interposition d'un écran entre les deux électrodes.

3. Procédé selon la revendication 2, caractérisé en ce que l'écran et les tranches sont mobiles les uns par rapport aux autres.

4. Réacteur pour la gravure ionique réactive de tranches de silicium du type comportant une enceinte sous vide comportant une électrode-support reliée (34) à un générateur et une électrode (35) réliée à la masse entre lesquelles est créé un plasma, des moyens de mise sous vide, des moyens de chargement et déchargement des tranches, des moyens d'introduction de gaz de gravure, caractérisé en ce qu'il comporte au moins deux emplacements (40) de tranche (33), des moyens pour soustraire au moins un emplacement à l'influence du plasma (37), lesdits moyens et les emplacements étant mobiles les uns par rapport aux autres, et des moyens d'analyse des espèces gazeuses du plasma.

5. Réacteur selon la revendication 4, caractérisé en ce que desdits moyens pour soustraire sont constitués par au moins un écran.

6. Réacteur selon la revendication 4 ou 5, caractérisée en ce que l'écran est en alliage d'aluminium.

7. Réacteur selon l'une des revendications 4 à 6, caractérisé en ce que l'écran est à une distance de 1 mm des tranches.

8. Réacteur selon l'une des revendications 4 à 7, caractérisé en ce qu'il comporte des moyens pour déplacer l'électrode-support notamment en rotation.

9. Réacteur selon l'une des revendications 4 à 8, caractérisé en ce qu'il comporte des moyens pour déplacer l'écran.

FIG.1

(a)          (b)          FIG.2

FIG.3

FIG.4

FIG.5

FIG.6

FIG.7

Office européen
des brevets

RAPPORT DE RECHERCHE EUROPEENNE

Numero de la demande

EP  88 40 2101

# DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | IBM TECHNICAL DISCLOSURE BULLETIN, vol. 24, no. 1A, juin 1981, pages 35-38, Armonk, NY, US; J.K. HASSAN et al.: "Combination reactive ion/plasma etch system with batch capability and indvidual wafer treatment" * Figures; page 37, alinéas 1,2 * --- | 1-5,8,9 | H 01 J  37/32 C 23 F  4/00 |
| X | IBM TECHNICAL DISCLOSURE BULLETIN, vol. 20, no. 11A, avril 1978, pages 4637-4638, Armonk, NY, US; L.M. EPHRATH: "Providing individual etchstops for wafers in reactive ion etching" * En entier * --- | 1-5,8,9 | |
| A | PATENT ABSTRACTS OF JAPAN, vol. 8, no. 232 (C-248)[1669] 25 octobre 1984, page 86; & JP-A-59 113 184 (MATSUSHITA DENKI SANGYO K.K.) 29-06-1984 * Résumé * ----- | 1,4 | |

DOMAINES TECHNIQUES RECHERCHES (Int. Cl.4)

H 01 J  37/00
C 23 F  4/00

Le présent rapport a été établi pour toutes les revendications

| Lieu de la recherche | Date d'achèvement de la recherche | Examinateur |
|---|---|---|
| LA HAYE | 23-11-1988 | SCHAUB G.G. |